(19) Europäisches Patentamt

European Patent Office

Office européen des brevets

(11) **EP 0 700 157 B1**

(12) **EUROPÄISCHE PATENTSCHRIFT**

(45) Veröffentlichungstag und Bekanntmachung des Hinweises auf die Patenterteilung:
**22.01.2003 Patentblatt 2003/04**

(51) Int Cl.[7]: **H03K 3/0233**

(21) Anmeldenummer: **95113183.8**

(22) Anmeldetag: **22.08.1995**

(54) **Hysteresebehafteter Komparator in Bipolar-Technik**

Comparator with hysteresis in bipolar technology

Comparateur à hystérésis en technologie bipolaire

(84) Benannte Vertragsstaaten:
**FR GB IT**

(30) Priorität: **24.08.1994 DE 4430032**

(43) Veröffentlichungstag der Anmeldung:
**06.03.1996 Patentblatt 1996/10**

(73) Patentinhaber: **SGS-THOMSON MICROELECTRONICS GMBH**
**85630 Grasbrunn (DE)**

(72) Erfinder: **Erckert, Ricardo**
**D-83043 Bad Aibling (DE)**

(74) Vertreter: **Klunker . Schmitt-Nilson . Hirsch**
**Winzererstrasse 106**
**80797 München (DE)**

(56) Entgegenhaltungen:
**FR-A- 2 422 288          US-A- 4 406 955**

• **GRAY & MEYER: "Analysis and design of Analog Integrated Circuits" 1984 , JOHN WILEY & SONS , NEW YORK XP002032445 12699 * Seite 282, Zeile 1 - Seite 283, Zeile 5; Abbildung 4.25 ***

**Beschreibung**

Die Erfindung betrifft einen hysteresebehafteten Komparator in Bipolar-Technik nach dem Oberbegriff des Anspruchs 1. Ein derartiger Komparator ist aus der FR-A-2 422 288 bekannt.

Eine häufige Anwendung von Komparatoren mit Hysterese ist die Erkennung von kleinen Eingangsspannungen. Typische Beispiele sind Logikeingänge, die durch einen Logikwert LOW ganze elektronische Systeme aktivieren, Schutzschaltungen, die beim Abfall einer Eingangs- oder Versorgungsspannung unter einen bestimmten Schwellenwert damit angesteuerte bzw. versorgte Schaltungen abschalten, und Reset-Generatoren. Hierfür werden Komparatoren benötigt, die bei Eingangssignalen oberhalb der Schaltschwelle so wenig Strom wie möglich verbrauchen. Der Stromverbrauch bei Eingangssignalen unterhalb der Schaltschwelle ist hingegen häufig von untergeordneter Bedeutung.

Es kann aber auch vorkommen, daß man Komparatoren mit Hysterese benötigt, die unterhalb einer Schaltschwelle so wenig Strom wie möglich verbrauchen, während ihr Stromverbrauch bei über der Schaltschwelle liegenden Eingangssignalen von untergeordneter Bedeutung ist.

Man benötigt somit hysteresebehaftete Komparatoren, die dann, wenn ihr Eingangssignal auf einer ersten Seite einer Schaltschwelle liegt, möglichst wenig Strom verbrauchen sollen, während der Stromverbrauch dann, wenn das Eingangssignal auf der anderen Seite der Schaltschwelle liegt, von untergeordneter Bedeutung ist. Auf welcher Seite der Schaltschwelle der Stromverbrauch möglichst niedrig sein soll, hängt von der einzelnen Anwendung ab.

Für diesen Zweck sind Schaltungen in CMOS-Technologie geeignet, die Strom nur während der Umschaltvorgänge verbrauchen. Schaltungen in CMOS-Technologie sind aber relativ unpräzise, wenn sie einen einfachen und wenig aufwendigen Schaltungsaufbau haben. Um sie präzise zu machen, benötigt man einen hohen Schaltungsaufwand.

Eine einfache CMOS-Schaltung in Form eines einfachen Schmitt-Triggers ist aus Fig. 1 der DE-A-38 37 821 bekannt. Fig. 4 dieser Druckschrift zeigt einen CMOS-Präzisions-Schmitt-Trigger, für den ein beachtlicher Schaltungsaufwand getrieben worden ist, um zu einem Schmitt-Trigger mit präziser Schaltschwelle zu kommen.

Aus der DE-A-42 15 423 ist ein Schmitt-Trigger in MOS-Technologie bekannt, bei dem die beiden zu Hysterese des Schmitt-Triggers führenden Schwellenwerte durch zwei unterschiedliche Komparatoren erzeugt werden, von denen einer oberhalb eines oberen Schwellenwertes leitet und unterhalb des oberen Schwellenwertes stromlos ist, während der andere Komparator oberhalb des unteren Schwellenwertes stromlos ist und unterhalb des unteren Schwellenwertes leitet. Damit die Gesamtschaltung sowohl oberhalb des oberen Schwellenwertes als auch unterhalb des unteren Schwellenwertes außerhalb der Umschaltvorgänge stromlos ist, wird mittels eines Flipflop einerseits der Schaltzustandswechsel des jeweils vom stromlosen in den stromleitenden Zustand umschaltenden Komparators gespeichert und wird außerdem der in den stromleitenden Zustand gelangte Komparator unmittelbar nach dessen Schaltzustandswechsel in einen stromlosen Zustand geschaltet.

Bipolarschaltungen können mit weniger Aufwand präziser als Schaltungen in MOS-Technologie hergestellt werden. Herkömmliche hyteresebehaftete Komparatoren in Bipolar-Technik verbrauchen jedoch in beiden Schaltzuständen gleich viel Strom, da die Hysterese entweder durch Umschalten von Strömen aus einer Strombank (ein Beispiel hierfür ist die integrierte Schaltung TLE 4211, gezeigt auf Seite 699 des Buches "Industrial and Automotive ICs", Siemens, 1990) oder durch eine positive Rückkopplung (ein Beispiel in Form eines "Comparator with hysteresis" zeigt Seite 9-37 des "Data Book 1976" von Fairchild) bewirkt wird.

Des weiteren ist ein Komparator in Bipolar-Technik bekannt, der bei Bandgap-Spannung schaltet und auch Bandgap-Schmitt-Trigger genannt wird. Ein Beispiel hierfür zeigt Fig. 4 der DE-A-42 15 423. Ein Bandgap-Komparator hat eine nur wenig temperaturabhängige Schaltschwelle von etwa 1,2 V. Er beginnt aber bereits bei einem Eingangssignal weit unterhalb dieser Schaltschwelle Strom zu verbrauchen und tut dies auch oberhalb der Schaltschwelle. D. h., er verbraucht im größten Teil seines Betriebsbereichs Strom.

Ein Bandgap-Komparator oder -Schmitt-Trigger, der in üblicher Weise zwischen eine Versorgungsspannungsquelle mit einem Pol auf positivem Potential und einem Massepol geschaltet ist, wird mit pnp-Transistoren aufgebaut. Damit liegt fest, daß er bei niedrigen Eingangssignalen unterhalb seiner Schaltschwelle stromsparend ist und bei Eingangsspannungen oberhalb seiner Schaltschwelle stromverbrauchend arbeitet, mit der bereits geschilderten Unschärfe, daß er bereits weit vor Erreichen der Schaltschwelle zunehmend Strom verbraucht. Benötigt man einen Komparator oder Schmitt-Trigger mit umgekehrtem Verhalten, der sich bei niedrigen Eingangsspannungen stromverbrauchend und bei hohen Eingangsspannungen stromsparend verhält, läßt sich dies nicht durch Aufbau mit Transistoren entgegengesetzten Leitfähigkeitsverhaltens erreichen. Denn in diesem Fall wäre die Eingangsspannung nicht mehr auf ein Referenzpotential in Form des Massepotentials bezogen sondern auf das positive Versorgungsspannungspotential der Spannungsquelle. Diese ist aber im allgemeinen nicht hinreichend konstant, um ein genügend zuverlässiges Arbeiten des Bandgap-Komparators zu ermöglichen.

Man könnte auch an die Verwendung von hysteresebehafteten Komparatoren in Mischtechnologie denken, also in Form von integrierten Schaltungen, die sowohl die MOS- als auch die Bipolar-Technologie verwenden. Schaltungen in Mischtechnologie sind jedoch teuer, weil zur Herstellung einer derartigen integrierten Schaltung viele Masken und entsprechend viele Herstellungsschritte erforderlich sind.

Für den Fall, daß eine einfache und wenig aufwendige und somit billige, aber dennoch präzise Komparatorschaltung mit Hysterese benötigt wird, soll daher eine Schaltung geschaffen werden, die zwar in Bipolar-Technologie ausgeführt ist, jedoch trotzdem im Ruhezustand, also bei Eingangssignalen, die auf einer bestimmten Seite der Schaltschwelle liegen, so wenig Strom wie möglich verbrauchen soll. Auf welcher Seite der Schaltschwelle dies zutrifft, hängt von dem Erfordernis der einzelnen Anwendung ab und soll je nach Bedarf realisiert werden können.

Eine Lösung dieser Aufgabe ist im Anspruch 1 angegeben.

Der Spannungs/Strom-Wandler kann einen Differenzverstärker aufweisen, dessen einem Eingang ein zu überwachendes Spannungssignal zugeführt wird, dessen zweiter Eingang mit einem Referenzpotential beaufschlagt wird und dessen Ausgang mit dem Stromeinspeisungsanschluß der bistabilen Stromquelle gekoppelt ist.

Ein derartiger Differenzverstärker ist an sich bekannt, beispielsweise aus Seite 435 des Buches "Microelectronics" von Jacob Millman, 2. Auflage, Verlag McGraw-Hill, 1988.

Für den erfindungsgemäßen Komparator wird ein Differenzverstärker bevorzugt, der neben zwei Verstärkertransistoren eine Stromspiegelschaltung aufweist. Der mit dem Stromeinspeisungsanschluß der bistabilen Stromquelle verbundene Stromspiegeltransistor weist dabei vorzugsweise eine Emitterfläche auf, die n-mal so groß wie die Emitterfläche des als Diode geschalteten Stromspiegeltransistors ist.

Bei einer bevorzugten Ausführungsform des erfindungsgemäßen Komparators weist die bistabile Stromquelle zwei Stromspiegelschaltungen auf, die eine in sich rückgekoppelte Ringschaltung bilden, wobei zwischen den Stromspiegeltransistor der einen Stromspiegelschaltung und den benachbarten Pol einer Spannungsversorgungsquelle ein Widerstand geschaltet ist. Der mit dem Widerstand verbundene Stromspiegeltransistor kann eine Emitterfläche aufweisen, die m-mal so groß ist wie die Emitterfläche des als Diode geschalteten Transistors der selben Stromspiegelschaltung.

Eine bistabile Stromquelle dieser Art ist an sich bekannt, und zwar aus dem Buch "Analysis and Design of Analog Integrated Circuits" von Paul R. Gray und Robert G. Meyer, 1984, Verlag John Wiley & Sons, Seite 283. Derartige Stromquellen werden bisher im allgemeinen als Referenzstromquellen in integrierten Schaltungen verwendet, wobei sie in demjenigen ihrer beiden möglichen Arbeitspunkte betrieben werden, in dem sie Strom liefern und somit aus der Energieversorgungsquelle auch Strom ziehen. Im anderen Arbeitspunkt ist die Stromquelle stromlos. Dieser Arbeitspunkt neigt zu Instabilität, wie in dem Buch von Gray und Meyer angegeben ist.

Der Erfindung liegt die Erkenntnis zugrunde, daß einerseits der an sich instabile Arbeitspunkt dadurch stabil gemacht werden kann, daß der Stromquelle Strom entzogen wird, und daß andererseits der Strom zum Zünden der Stromquelle in deren stromziehendem stabilen Arbeitspunkt vom Strom zum Löschen der Stromquelle, also zu deren Überführung aus dem stromziehenden Zustand in den stromlosen Zustand, unterschiedliche Stromwerte haben.

Diese Erkenntnis wird bei der Erfindung ausgenutzt, indem der Ausgangsanschluß eines Spannungs/Strom-Wandlers, vorzugsweise in Form eines Differenzverstärkers, mit einem Stromeinspeisungsanschluß der Stromquelle verbunden wird. Und da der Ausgangsstrom des Spannungs-/Strom-Wandlers von dessen Eingangsspannung abhängt, hängt es vom Wert dieser Eingangsspannung ab, ob sich die Stromquelle im gezündeten, stromverbrauchenden Arbeitspunkt oder im gelöschten, stromlosen Arbeitspunkt befindet. Da aber Zünden und Löschen der Stromquelle bei verschiedenen Ausgangsströmen des Spannungs/Strom-Wandlers stattfinden, weist die Gesamtschaltung aus Spannungs/Strom-Wandler und Stromquelle eine Hysterese auf. Diese Gesamtschaltung kann daher als hysteresebehafteter Komparator verwendet werden, der je nach dem, ob die Eingangsspannung unter einem unteren Schwellenwert oder über einem oberen Schwellenwert liegt, einen Ausgangsstrom liefert oder nicht. Jenseits des einen Schwellenwertes verbraucht die Gesamtschaltung praktisch keinen Strom, während sie jenseits des anderen Schwellenwertes Strom verbraucht.

Jenseits welchen der beiden Schwellenwerte die Gesamtschaltung praktisch stromlos ist bzw. Strom verbraucht, kann durch den speziellen Schaltungsaufbau ausgewählt werden. Bildet man den Spannungs-/Strom-Wandler in bevorzugter Weise als Differenzverstärker aus, kann der Schwellenwert, jenseits welchem praktisch kein Strom verbraucht wird, durch Wahl desjenigen Eingangs des Differenzverstärkers, welchem ein Referenzpotential zugeführt wird, bestimmt werden. Eine andere Möglichkeit zur Bestimmung, jenseits welchen Schwellenwertes die Gesamtschaltung praktisch stromlos sein soll, besteht in der Auswahl der Leitfähigkeitstypen der verwendeten Transistoren.

Es bestehen zwei Möglichkeiten, bei dem erfindungsgemäßen Schaltungsaufbau, der als Spannungs/Strom-Wandler einen Differenzverstärker verwendet, die Größe der Hysterese zu erhöhen. Die eine Möglichkeit ist die, zwischen den Schaltungspunkt, in welchem beide Verstärkertransistoren mit einer Vorspannstromquelle verbunden sind, und die beiden Verstärkertransistoren je eine Impedanz, vorzugsweise in Form mindestens einer Diode, zu schalten. Eine weitere Möglichkeit besteht in einer Rückkopplung eines dem Ausgangsstrom der Stromquelle proportionalen Spannungssignals auf einen Spannungseingang des Spannungs/Strom-Wandlers, im Fall der Verwendung eines Differenzverstärkers als Spannungs/Strom-Wandlers vorzugsweise auf den Eingang des Differenzverstärkers, der mit dem Referenzpotential beaufschlagt wird. Beide Maßnahmen zur Vergrößerung der Hysterese können auch kombiniert werden.

Mit der Erfindung ist ein integrierter Komparator verfügbar gemacht worden, der einen relativ einfachen und damit kostengünstigen Aufbau aufweist, je nach Schaltungsauslegung unterhalb eines Schwellenwertes praktisch stromlos ist und oberhalb eines Schwellenwertes Strom leitet oder umgekehrt unterhalb eines Schwellenwertes Strom leitet und oberhalb eines Schwellenwertes praktisch stromlos ist, und der infolge der Anwendung von Bipolar-Technologie sehr genau arbeitet.

Die Erfindung wird nun anhand von Ausführungsformen näher erläutert. In den Zeichnungen zeigen:

Fig. 1 ein Prinzipschaltbild einer bevorzugten Ausführungsform eines erfindungsgemäßen hysteresebehafteten Komparators;

Fig. 2 ein Schaltbild einer praktischen Verwirklichung der in Fig. 1 gezeigten Ausführungsform;

Fig. 3 eine Stromkennlinie, aus welcher ein Zündstrom und ein Löschstrom des Stromgenerators einer erfindungsgemäßen Schaltung hervorgehen;

Fig. 4 eine Kennlinie, aus welcher die Abhängigkeit des Zündens und Löschens der Stromquelle von der Eingangsspannung des Differenzverstärkers der in Fig. 2 gezeigten Schaltung hervorgeht;

Fig. 5 eine erste Modifikation der in Fig. 2 gezeigten Ausführungsform mit Rückkopplung zur Vergrößerung der Hysterese; und

Fig. 6 eine zweite Modifikation der in Fig. 3 gezeigten Ausführungsform mit vergrößerter Hysterese.

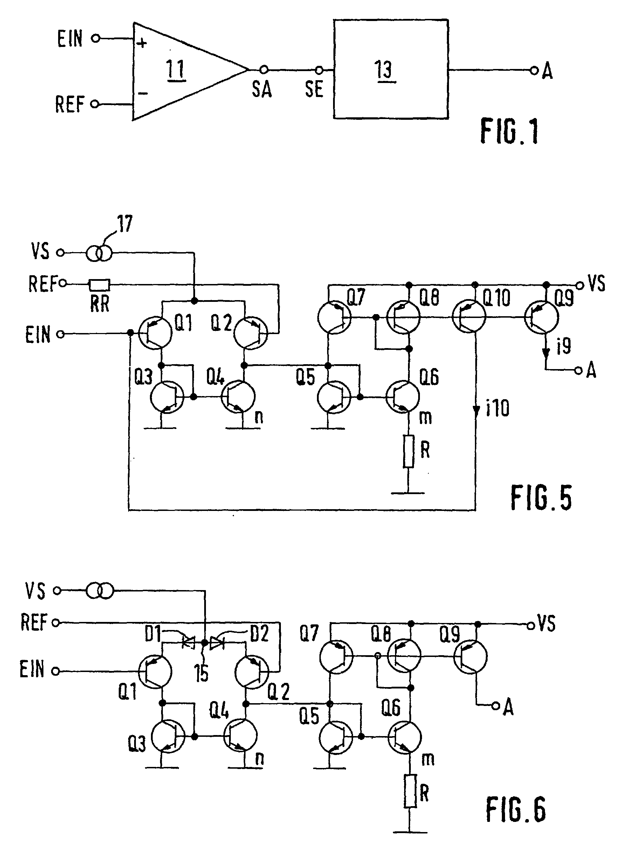

Fig. 1 zeigt in Blockschaltbilddarstellung eine bevorzugte Ausführungsform eines erfindungsgemäßen hysteresebehafteten Komparators mit einem Spannungs/Strom-Wandler in Form eines Differenzverstärkers 11 und einer bistabilen Stromquelle 13. Auf einen nicht-invertierenden Eingang EIN wird eine mit der Schwelle des Komparators zu vergleichende Eingangsspannung VIN gegeben. Ein invertierender Eingang - ist mit einem Referenzpotential REF verbunden. Ein Stromausgang SA des Differenzverstärkers 11 ist mit einem Stromeinspeisungsanschluß SE der Stromquelle 13 verbunden. Ein Stromausgangsanschluß der Stromquelle 13 bildet den Ausgang A des Komparators.

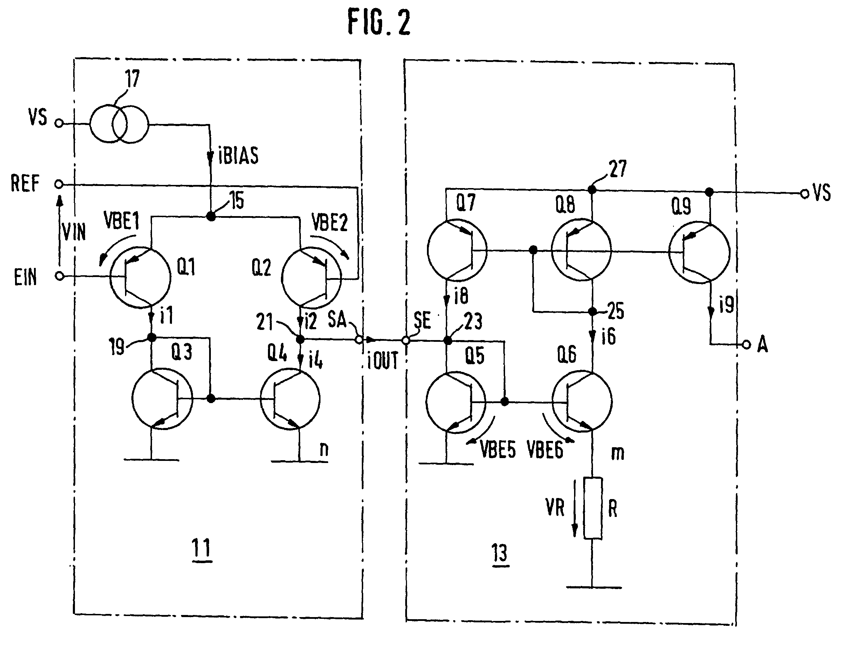

Fig. 2 zeigt ein Schaltbild einer Schaltungsanordnung, mit welcher der in Fig. 1 gezeigte Komparator verwirklicht werden kann. Die zwei Schaltungsteile, welche den Differenzverstärker 11 und die Stromquelle 13 darstellen, sind durch gestrichelte Blöcke gekennzeichnet.

Der Differenzverstärker 11 weist einen Verstärkerteil mit einem ersten Transistor Q1 und einem zweiten Transistor Q2 sowie einen Stromspiegelteil mit einem als Diode geschalteten dritten Transistor Q3 und einem vierten Transistor Q4 auf. Dabei sind Q1 und Q3 einerseits sowie Q2 und Q4 andererseits je in Reihe geschaltet. Die beiden Transistoren Q1 und Q3 sind in einem Schaltungspunkt 19 und die Transistoren Q2 und Q4 sind in einem Schaltungspunkt 21 miteinander verbunden. Zwischen den Basisanschlüssen der beiden Transistoren Q1 und Q2 liegt die Eingangsspannung VIN, die mit der Schwelle des Komparators verglichen werden soll.

Die bistabile Stromquelle 13 weist einen unteren Stromspiegel mit einem als Diode geschalteten Transistor Q5 und einem Transistor Q6 sowie einen oberen Stromspiegel mit einem Transistor Q7, einem als Diode geschalteten Transistor Q8 und einem Transistor Q9 auf. Die Transistoren Q5 und Q7 sind in Reihe geschaltet und in einem Schaltungspunkt 23 miteinander verbunden. Die Transistoren Q8 und Q6 bilden eine weitere Reihenschaltung und sind in einem Schaltungspunkt 25 miteinander verbunden. Die Emitter der Transistoren Q5 und Q6 sind mit Masse verbunden, und zwar Q5 direkt und Q6 über einen Widerstand R.

Die Emitter der Transistoren Q7, Q8 und Q9 sind in einem Schaltungspunkt 27 miteinander verbunden, der seinerseits mit dem positiven Pol VS der Versorgungsspannungsquelle verbunden ist.

Der Differenzverstärker 11 und die Stromquelle 13 sind durch Verbindung der beiden Schaltungspunkte 21 und 23 miteinander verbunden. Dabei bildet der Schaltungspunkt 21 den Stromausgang SA des Differenzverstärkers 11 und der Schaltungspunkt 23 bildet den Stromeinspeisungsanschluß SE der bistabilen Stromquelle 13. Der Kollektor des Transistors Q9 ist mit dem Ausgangsanschluß A des Komparators verbunden.

Bei dem in Fig. 2 dargestellten Ausführungsbeispiel sind die mit dem Versorgungspotential VS verbundenen Transistoren Q1, Q2, Q7, Q8 und Q9 durch bipolare pnp-Transistoren gebildet, während die mit dem Masseanschluß verbundenen Transistoren Q3 bis Q6 durch bipolare npn-Transistoren gebildet sind.

Der Transistor Q4 weist eine Emitterfläche auf, die n-mal so groß wie die Emitterfläche des als Diode geschalteten Transistors Q3 ist. Der Transistor Q6 des unteren Stromspiegels der Stromquelle 13 weist eine Emitterfläche auf, die m-mal so groß wie die Emitterfläche des als Diode geschalteten Transistors Q5 dieses Stromspiegels ist.

Es wird nun die Funktionsweise der in Fig. 2 gezeigten Ausführungsform erläutert. Zunächst wird die Funktionsweise des Differenzverstärkers 11 betrachtet. Danach folgt eine Betrachtung der Funktionsweise der Stromquelle 13. Schließlich wird noch die Gesamtfunktion der in Fig. 2 gezeigten Schaltung betrachtet.

Funktionsweise des Differenzverstärkers 11:

Die Stromquelle 17 liefert einen Strom iBIAS. Die Kollektorströme der Transistoren Q1 und Q2 sind i1 bzw. i2. Der Kollektorstrom des Transistors Q4 ist i4. Der vom Schaltungspunkt 21 zur Stromquelle 13 fließende Strom wird mit iOUT bezeichnet.

Nach Ebers, Moll gilt für die Kollektorströme i1 und i2:

$$i1 = is \cdot \exp \frac{VBE1}{VT} \qquad (1)$$

$$i2 = is \cdot \exp \frac{VBE2}{VT} \qquad (2)$$

Dies gilt für die Näherung i1, i2 > > is mit der bekannten Formel

$$VT = \frac{K \cdot T}{e} \qquad (3)$$

für die Temperaturspannung VT.

Durch Umformen der Gleichung

$$\frac{i1}{i2} = \frac{is \cdot \exp (VBE1/VT)}{is \cdot \exp (VBE2/VT)} \qquad (4)$$

erhält man

$$\frac{i1}{i2} = \exp \frac{(VBE1 - VBE2)}{VT} \qquad (6)$$

Bezeichnet man die Basis-Emitter-Spannungen der Transistoren Q1 und Q2 als VBE1 bzw. VBE2, erhält man nach dem Kirchhoff'schen Gesetz

$$VBE1 + VIN - VBE2 = 0 \qquad (6)$$

Durch Umformen erhält man

$$VBE1 - VBE2 = -VIN \qquad (7)$$

Setzt man Gleichung (7) in Gleichung (5) ein, erhält man für das Verhältnis der Kollektorströme i1 und i2

$$\frac{i1}{i2} = \exp (-VIN/VT) \qquad (8)$$

Unter der Vernachlässigung der Basisströme von Q1 und Q2 gilt

$$i1 + i2 = iBIAS \qquad (9)$$

Daraus folgt

$$i1 = iBIAS - i2 \qquad (10)$$

und

$$i2 = iBIAS - i1 \qquad (11)$$

Setzt man in Gleichung (10) den für i2 aus Gleichung (8) sich ergebenden Ausdruck ein, und multipliziert man die dadurch erhaltene Gleichung mit exp (-VIN/VT), erhält man nach Umformung und Auflösung nach i1

$$i1 = iBIAS - \frac{i1}{\exp (-VIN/VT)} \qquad (12)$$

Durch Zuhilfenahme von Gleichung (8) und Auflösung nach i1 bzw. i2 erhält man

$$i1 = iBIAS \cdot \frac{1}{1 + \exp (VIN/VT)} \qquad (13)$$

und

$$i2 = iBIAS \cdot \frac{1}{1 + \exp (-VIN/VT)} \qquad (14)$$

Die Transistoren Q3 und Q4 arbeiten als Stromspiegel mit dem Übersetzungsverhältnis n. Daraus ergibt sich

$$i4 = n \cdot i1 \qquad (15)$$

Der von dem Differenzverstärker 11 an die Stromquelle 13 abgegebene Strom iOUT errechnet sich zu

$$iOUT = i2 - i4 \qquad (16)$$

Durch Einsetzen von Gleichung (15) in Gleichung (16) erhält man

$$iOUT = i2 - n \cdot i1 \qquad (17)$$

Durch Einsetzen der Gleichungen (13) und (14) in Gleichung (17) erhält man nach Umformungen

$$iOUT = iBIAS \cdot \frac{1 - n \cdot \exp(-VIN/VT)}{1 + \exp(-VIN/VT)} \qquad (18)$$

Gleichung (18) zeigt, daß der vom Differenzverstärker 11 an die Stromquelle 13 abgegebene Strom iOUT abhängig ist vom Strom iBIAS der Stromquelle 17 des Differenzverstärkers 11, vom Verhältnis n der Emitterflächen der Transistoren Q4 und Q3 und von der Eingangsspannung VIN des Differenzverstärkers 11. Da der von der Stromquelle 17 abgegebene Strom iBIAS und das Emitterflächenverhältnis n konstant sind, hängt der Ausgangsstrom iOUT des Differenzverstärkers 11 direkt von der Eingangsspannung VIN ab.

Für normale Differenzverstärker wird n = 1 gewählt. Die Wahl n > 1 ist sinnvoll, wenn iOUT stark negative Werte annehmen können soll.

Funktionsweise der bistabilen Stromquelle:

Es folgen nun Betrachtungen zu der bistabilen Stromquelle 13. Dabei werden die Kollektorströme der Transistoren Q5, Q6, Q8 und Q9 bezeichnet mit i5, i6, i8 bzw. i9. Über dem Widerstand R fällt die Spannung VR ab. Wie bereits erwähnt, hat der Transistor Q6 die m-fache Emitterfläche von Transistor Q5.

In den folgenden Berechnungen werden die Basisströme der Transistoren wieder vernachlässigt.

Am Kollektor des Transistors Q5 gilt folgende Strombilanz:

$$i5 = iOUT + i8 \qquad (19)$$

Die Funktion des Stromspiegels Q7 und Q8 führt zu

$$i8 = i6 \qquad (20)$$

Für den Spannungsabfall über dem Widerstand R ergibt sich

$$VR = i6 \cdot R \qquad (21)$$

Nach Ebers und Moll gilt für die Ströme i5 und i6:

$$i5 = is \cdot \exp(VBE5/VT) \qquad (22)$$

und

$$i6 = is \cdot m \cdot \exp(VBE6/VT) \qquad (23)$$

Dies gilt für i5, i6 > > is. Diese Annahme ist zulässig, da übliche Werte für is bei $10^{-15}$A liegen. Bildet man das Verhältnis zwischen den Strömen i6 zu i5 unter Zuhilfenahme der Gleichungen 22 und 23, erhält man

$$\frac{i6}{i5} = \frac{m \cdot is \cdot \exp(VBE6/VT)}{is \cdot \exp(VBE5/VT)} \qquad (24)$$

Dies führt nach Umformungen zu

$$\frac{i6}{i5} = m \cdot \exp\left(\frac{VBE6 - VBE5}{VT}\right) \qquad (25)$$

Mit den Basis-Emitterspannungen VEB5 und VEB6 der Transistoren Q5 und Q6 folgt aus dem Kirchhoff'schen Gesetz

$$VEB6 + VR - VEB5 = 0 \qquad (26)$$

daraus folgt

$$VEB6 - VEB5 = -VR \qquad (27)$$

Durch Einsetzen von Gleichung 27 in Gleichung 25 erhält man

$$\frac{i6}{i5} = m \cdot \exp(-VR/VT) \qquad (28)$$

Ersetzt man in Gleichung (28) i5 durch Gleichung (19), erhält man

$$\frac{i6}{iOUT + i8} = m \cdot \exp(-VR/VT) \qquad (29)$$

Ersetzt man i8 gemäß Gleichung (20) durch i6, erhält man

$$\frac{i6}{iOUT + i6} = m \cdot \exp(-VR/VT) \qquad (30)$$

Durch beidseitiges Logarithmieren und anschließende Umformung und beidseitige Multiplikation mit VT kommt man zu

$$i6 = \frac{VT}{R}\left[\ln(m) + \ln\left(\frac{iOUT + i6}{i6}\right)\right] \qquad (31)$$

Für die meisten Fälle ist Gleichung (31) nur durch eine iterative Methode zu lösen. Solche Methoden sind aus der nichtlinearen Netzwerkanalyse an sich bekannt. Für den Sonderfall iOUT = 0 ist eine analytische Lösung möglich, weil für diesen Fall der zweite Term in Gleichung (31) zu ln (1) = 0 wird. Für diesen Fall, für den der Kollektorstrom von Q6 mit $i6_0$ bezeichnet wird folgt

$$i6_0 = \ln(m) \cdot \frac{VT}{R} \qquad (32)$$

Dies ist der Strom, der für einen Transistor Q6 mit einer Emitterfläche, die zweimal so groß ist wie die des Transistors Q5 in Gleichung 4.193 auf Seite 331 des bereits erwähnten Buches "Analysis and Design of Analogue Integrated Circuits", angegeben ist.

Im folgenden werden die Zündbedingung und die Löschbedingung der bistabilen Stromquelle 13 gesucht.

Vor der Zündung der Stromquelle 13, solange diese also stabil in ihrem stromlosen Arbeitspunkt gehalten wird, fließt kein Strom durch die Stromquelle 13, so daß i6 = 0 ist. Der Term in den eckigen Klammern von Gleichung (31) muß daher 0 ergeben. Für diesen stromlosen Zustand folgt hieraus

$$\frac{iOUT + i6}{i6} = \frac{1}{m} \qquad (33)$$

Aufgelöst nach iOUT erhält man

$$iOUT = i6 \left(\frac{1-m}{m}\right) \qquad (34)$$

Vor der Zündung der Stromquelle 13 ist i6 = 0. Daraus ergibt sich als Bedingung für die Zündung der Stromquelle

$$iOUT > 0 \qquad (35)$$

Möchte man die gezündete Stromquelle 13 löschen, muß man den Strom i6 zu 0 machen. Daher gilt die Gleichung (34) auch als Löschbedingung. Bevor die Stromquelle 13 gelöscht ist, ist jedoch i6 > 0 und daher gilt im Fall der Löschung

$$iOUT < i6 \left(\frac{1-m}{m}\right) \qquad \text{mit } i6 > 0 \qquad (36)$$

Der Strom i6 in der Beziehung (36) errechnet sich wieder aus Gleichung (31). Die Beziehungen (31) und (36) müssen wieder iterativ gelöst werden.

Für ein Beispiel einer solchen iterativen Lösung wird mit einer analytischen Lösung begonnen mit den Werten

$$iOUT = 0$$

$$m = 3$$

$$R = 14 \, K\Omega$$

Für iOUT = 0 gilt wieder Gleichung (32). Setzt man in Gleichung (32) die eben angegebenen Werte für m und R ein sowie in bekannter Weise für VT = 26mV, kommt man zu

$$i6_0 = \frac{VT}{R} \ln(m) = 2{,}04 \, \mu A \qquad (37)$$

Für eine Iteration mit den oben angegebenen Werten wird ein Wert von iOUT = -0,5 µA angenommen. Mit dem oben für $i6_0$ errechneten Startwert von 2,04 µA führt ein Iterationsverfahren unter Zuhilfenahme der Gleichung (31), dessen einzelne Schritte hier nicht wiedergegeben werden, beim sechsten Iterationsschritt zu einem Wert i6 < 0. Da der Strom i6 der Stromquelle 13 in deren gezündetem Zustand nicht kleiner als 0 sein kann, bedeutet dies, daß ein Stromabriß aufgetreten ist. D.h., mit dem für die Iteration angenommenen Wert iOUT = -0,5 µA erfolgt bei einer Schaltung mit den oben angegebenen speziellen Werten ein Stromabriß und somit eine Löschung der Stromquelle 13.

Eine Worst-Case-Rechnung auf der Grundlage der Gleichung (36) und unter Vernachlässigung des Widerstandes R ergibt, daß der Stromabriß sicher bei spätestens

$$iOUT < 2{,}04 \, \mu A \cdot (-2/3) = -1{,}36 \, \mu A \qquad (38)$$

stattfindet.

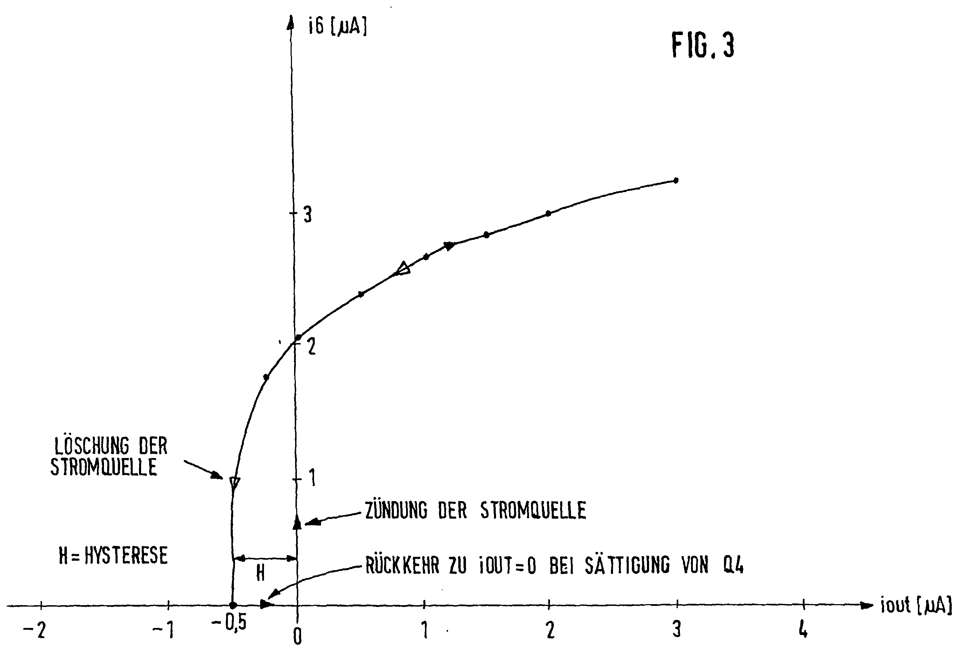

Figur 3 zeigt die Abhängigkeit des Kollektorstroms i6 des Transistors Q6 der Stromquelle 13 in Abhängigkeit von dem Ausgangsstrom iOUT des Differenzverstärkers 11, erhalten durch eine iterative Berechnung.

Erhöht man den Strom iOUT vom Stromwert -2µA kommend, bleibt der Strom i6 solange 0, wie iOUT negative Werte aufweist. Gemäß der Zündbedingung nach Beziehung (35) zündet die Stromquelle 13, sobald der Wert des Stroms iOUT > 0 wird. Aufgrund der Rückkopplung der beiden Stromspiegel Q5, Q6 und Q7, Q8 der Stromquelle 13 folgt ein schlagartiger Anstieg des Stroms i6, entsprechend dem bistabilen Verhalten der Stromquelle 13, auf einen von 0 verschiedenen Wert. Unter den oben angegebenen beispielhaften Werten für m und R ergibt sich im Zündzeitpunkt ein Strom $i6_0$ = 2,04 µA, wie er auch in Figur 3 eingetragen ist. Bei zunehmendem Wert des Stroms iOUT nach dem Zünden nimmt i6 in der in Figur 3 gezeigten Weise zu.

Um die Stromquelle 13 zu löschen, muß iOUT bis zu dem für das Löschen erforderlichen Stromwert abgesenkt werden. Gemäß der oben erwähnten Iterationsrechnung erfolgt ein Stromabriß bei einem Strom von iOUT = -0,5µA.

Zum Löschen der Stromquelle 13 muß iOUT also auf einen Wert abgesenkt werden, der niedriger ist als der zum Zünden der Stromquelle 13 erforderliche Stromwert. Dies bewirkt die Hysterese des erfindungsgemäßen Komparators.

Funktion des Komparators:

Es wird nun die Funktion der Gesamtschaltung betrachtet und deren Hysterese ermittelt. Mit den Werten von iOUT, die zuvor - teilweise mittels iterativer Berechnung - für Zündung und Löschen der Stromquelle 13 ermittelt worden sind, kann mit Hilfe der Gleichung (18) die für das Zünden und die für das Löschen der Stromquelle 13 je erforderliche Eingangsspannung VIN des Differenzverstärker 11 berechnet werden.

Im Fall der Zündung ist iOUT = 0 (siehe Gleichung 34). Aus Gleichung (18) ergibt sich daher

$$iBIAS \cdot \frac{1 - n \cdot exp\,(-VIN/VT)}{1 + exp\,(-VIN/VT)} = 0 \qquad (39)$$

Die Betrachtung des Zählers von (39) alleine liefert

$$1 - n \cdot exp\,(-VIN/VT) = 0 \qquad (40)$$

Durch Umformung erhält man

$$VIN = ln(n) \cdot VT \qquad (41)$$

Zum Zünden der Stromquelle 13 muß somit eine Eingangsspannung mit einem Wert entsprechend Gleichung (41) zugeführt werden. Bei einer praktischen Ausführungsform der in Figur 2 gezeigten Schaltung hat der Transistor Q4 eine Emitterfläche, die n-mal so groß wie diejenige des Transistors Q3 ist. Hierfür ergibt sich aus der Gleichung (41) eine Eingangsspannung VIN = 36 mV.

Für den Löschungsfall gilt entsprechend

$$iBIAS \cdot \frac{1 - n \cdot exp\,(-VIN/VT)}{1 + exp\,(-VIN/VT)} = iOUT_{Lösch} \qquad (42)$$

Gleichung (42) erfordert wiederum eine iterative Lösung. Nimmt man gemäß der obigen Ermittlung für die Löschbedingung einen Strom iOUT = - 0,5 µA, einen Strom iBIAS = 1 µA und ein Verhältnis der Emitterflächen der Transistoren Q4 und Q3 von n = 4 an, führt eine solche iterative Lösung zu einer Eingangsspannung VIN = 21 mV für das Löschen der Stromquelle.

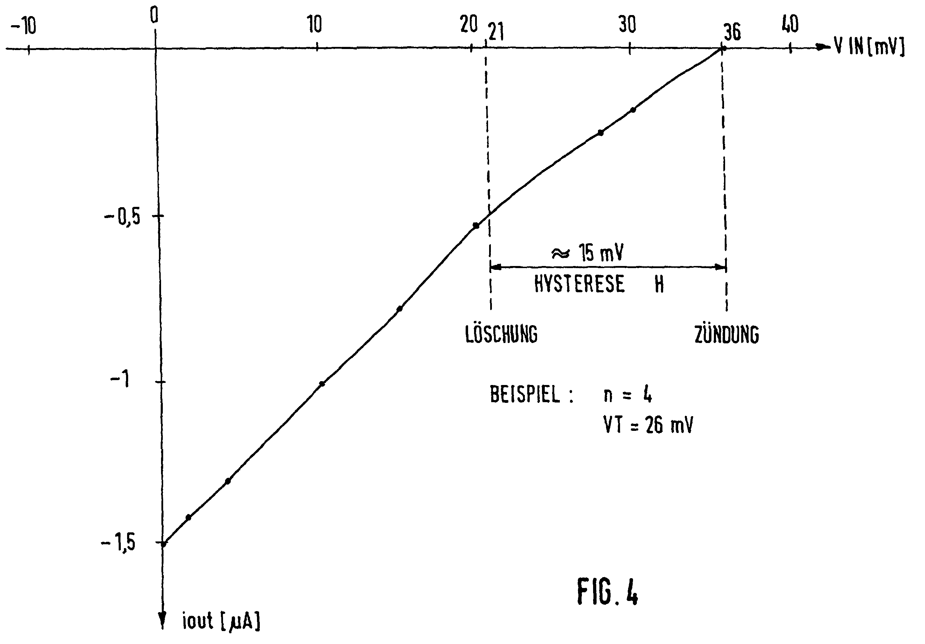

Dies ist in Figur 4 grafisch veranschaulicht, in welcher der Ausgangsstrom iOUT des Differenzverstärkers 11 in Abhängigkeit von der Eingangsspannung VIN aufgetragen ist. In diese Figur sind die Spannungswerte für VIN eingetragen, die für das Zünden und Löschen der Stromquelle 13 erforderlich sind. Bei dem angenommenen Ausführungsbeispiel mit den speziellen Werten findet ein Zünden der Stromquelle 13 statt, wenn die Differenzverstärker-Eingangsspannungg VIN eine Schwelle von 36 mV überschreitet. Zum Löschen der gezündeten Stromquelle 13 kommt es, wenn die Differenzverstärker-Eingangsspannung VIN einen Wert von 21 mV unterschreitet. Die Differenz zwischen der Zündspannung von 36 mV und der Löschspannung von 21 mV stellt die Hysterese der Komparatorschaltung dar. In dem in Figur 4 wiedergegebenen Beispiel beträgt die Hysterese 15 mV.

Wenn man die in Figur 2 gezeigte Komparatorschaltung so dimensioniert, wie es für die Figuren 3 und 4 angenommen ist, folgt:

Solange die Eingangsspannung des Differenzverstärkers 11 unter der Zündspannung von 36 mV liegt, bleibt die Stromquelle 13 stromlos. Wird die Zündspannung von 36 mV überschritten, wird die Stromquelle 13 gezündet, d.h. in den stromleitenden Zustand gebracht. Bei einer darauffolgenden Absenkung der Eingangsspannung VIN des Differenzverstärkers 11 erfolgt ein Löschen der Stromquelle 13 erst, wenn die Löschspannungsschwelle von 21 mV unterschritten wird. Erst dann geht die Stromquelle 13 wieder in den stromlosen Zustand über. Die 15 mV zwischen Zündspannung und Löschspannung bilden die Hysterese der Gesamtschaltung, also des erfindungsgemäßen Komparators.

Bei der in Figur 2 dargestellten Ausführungsform ist der Komparator bei einer oberhalb der Zündspannung liegenden Eingangsspannung stromführen, bei einer Eingangsspannung unterhalb der Löschspannung praktisch stromlos. Es fließt dann nur noch der geringfügige Strom iBIAS der Stromquelle 17.

Durch umgekehrte Beaufschlagung der beiden Eingangsanschlüsse des Differenzverstärkers 11, nämlich Anlegen der Eingangsspannung VIN an den invertierenden Eingang (Figur 1) des Differenzverstärkers 11 und des Referenzpotentials an den nicht-invertierenden Eingang kann man ein umgekehrtes Verhalten des Komparators erreichen. Ein solcher Komparator würde dann, wenn die Eingangsspannung VIN unterhalb einer unteren Schwelle liegt, Strom leiten, während er dann, wenn die Eingangsspannung VIN oberhalb einer oberen Schwelle liegt, praktisch stromlos ist.

Ein gleiches Ergebnis wäre dadurch erreichbar, daß man bei der in Figur 2 gezeigten Schaltung alle Transistoren Q1 bis Q9 durch Transistoren des entgegengesetzten Leitfähigkeitstyps ersetzt.

Ergänzend sei noch bemerkt, daß bei der in Figur 2 gezeigten Ausführungsform der Kollektorstrom i9 des Transistors Q9 gleich dem Kollektorstrom i6 des Transistors Q6 ist, weil die Transistoren Q7 bis Q9 einen Stromspiegel bilden, der in allen Stromspiegelzweigen den gleichen Strom führt. Der Ausgangsstrom i9 am Komparatorausgang A verhält sich daher genauso wie der Kollektorstrom i6 des Transistors Q6. Das heißt, die Überlegungen, die in den Figuren 3 und 4 für den Strom i6 angestellt worden sind, sind auf den Ausgangsstrom i9 des Komparators übertragbar.

Figur 5 zeigt eine Komparatorschaltung, die mit der in Figur 2 gezeigten Komparatorschaltung übereinstimmt mit der Ausnahme, daß der Eingang des Differenzverstärkers, dem das Referenzpotential zugeführt wird, auf den oberen Stromspiegel der bistabilen Stromquelle 13 rückgekoppelt ist. Zu diesem Zweck weist der obere Stromspiegel einen weiteren Transistor Q10 auf, dessen Kollektorstrom i10 dem Kollektorstrom i6 des Transistors Q6 und dem Ausgangsstrom i9 des Stromspiegels Q7 bis Q10 entspricht. Zwischen den Referenpotentialeingang des Differenzverstärkers und die Referenzpotentialquelle ist ein Widerstand RR geschaltet, mittels welchem der von der Stromquelle 13 kommende Rückkopplungsstrom i10 in eine entsprechende Spannung umgesetzt wird, die dem Referenzpotential der Referenzpotentialquelle überlagert wird.

Wenn sich die bistabile Stromquelle 13 im gezündeten und damit stromleitenden Zustand befindet, wird der von i10 am Widerstand RR verursachte Spannungsabfall zum Referenzpotential addiert. Dies führt dazu, daß bei einer Absenkung der Eingangsspannung das Ausschalten, also Löschen der Stromquelle 13 später passiert. Je nach Dimensionierung des Widerstandes RR kann daher eine wesentlich größere Hysterese erreicht werden als bei der in Figur 2 gezeigten Ausführungsform ohne eine derartige Rückkopplung.

Eine weitere Möglichkeit, die Hysterese zu vergrößern, ist bei der in Figur 6 dargestellten Ausführungsform gezeigt. Dabei ist zwischen den Schaltungspunkt 15 und den Emitter eines jeden der beiden Transistoren Q1 und Q2 je eine Diode D1 bzw. D2 geschaltet. Dies führt dazu, daß die Eingangsspannung VIN in jeder Schaltrichtung einen größeren Schwellenwert überschreiten muß, um die Stromquelle 13 zu zünden bzw. zu löschen. Die Hysterese wird dadurch vergrößert.

Soll die Hysterese noch mehr vergrößert werden, kann man dem Emitter eines jeden der beiden Transistoren Q1 und Q2 zwei oder mehr Dioden vorschalten.

Anstelle der Dioden können auch Widerstände zur Vergrößerung der Hysterese verwenden werden. Der Spannungsabfall, welchen der Strom iBIAS an jedem dieser beiden Widerstände erzeugt, führt zu einer entsprechenden Vergrößerung der Hysterese.

Die in den Figuren 5 und 6 gezeigten Maßnahmen zur Vergrößerung der Hysterese können auch kombiniert werden. Das heißt, man kann bei einer weiteren Ausführungsform sowohl die Rückkopplung gemäß Figur 5 als auch die den Emittern der Transistoren Q1 und Q2 vorgeschalteten Impedanzen bspw. Dioden anwenden, um eine akkumulative Vergrößerung der Hysterese zu erreichen.

Ein besonderer Vorteil des erfindungsgemäßen Komparators besteht darin, daß dessen gesamter Stromverbrauch in einer der beiden Schaltlagen lediglich der von der Stromquelle 17 des Differenzverstärkers 11 gelieferte Strom iBIAS ist. Dieser kann extrem klein gemacht werden.

**Patentansprüche**

1. Hysteresebehafterer Komparator in Bipolartechnik, bei dem alle Transistoren als Bipolartransistoren ausgebildet sind mit einem Spannungs/Strom-Wandler (11) mit einem den Komparatoreingangsanschluß bildenden Spannungseingang (EIN) und einem Stromausgang; **gekennzeichnet durch**

   a) eine bistabile Stromquelle (13) mit einem mit dem Stromausgang (SA) des Spannungs/Strom-Wandlers (11) gekoppelten Stromeinspeisungsanschluß (SE) und einem den Komparatorausgang (A) bildenden Stromausgangsanschluß; wobei

   b) die bistabile Stromquelle (13) in einem ersten stabilen Zustand stromlos ist und nur im zweiten stabilen Zustand Strom verbraucht; und

   c) der Zündstrom, der dem Stromeinspeisungsanschluß (SE) zugeführt werden muß, um die bistabile Stromquelle (13) vom stromlosen Zustand in den stromverbrauchenden Zustand zu schalten, von dem Löschstrom, der dem Stromeinspeisungsanschluß (SE) zugeführt werden muß, um die bistabile Stromquelle vom stromverbrauchenden Zustand in den stromlosen Zustand zu schalten, zum Erhalt einer Hysterese des Komparators voneinander verschieden sind.

2. Komparator nach Anspruch 1, **dadurch gekennzeichnet, daß** der Spannungs/Strom-Wandler einen Differenzverstärker (11) aufweist, dessen einem Eingang (+) ein zu überwachendes Spannungssignal (VIN) zugeführt wird, dessen zweiter Eingang (-) mit einem Referenzpotential (REF) beaufschlagt wird und dessen Ausgang (SA) mit dem Stromeinspeisungsanschluß (SE) der bistabilen Stromquelle (13) gekoppelt ist.

3. Komparator nach Anspruch 2, **dadurch gekennzeichnet**,

   a) daß der Differenzverstärker (11) in einem ersten Schaltungspunkt (15) gekoppelte Verstärkertransistoren (Q1, Q2) und eine Verstärkerstromspiegelschaltung (Q3, Q4) mit einer Stromspiegeldiode (Q3) in Form eines als Diode geschalteten Transistors und einem Stromspiegeltransistor (Q4) aufweist;

b) daß die beiden Verstärkertransistoren (Q1, Q2) von einem ersten Leitfähigkeitstyp (pnp) und die beiden Transistoren (Q3, Q4) der Verstärkerstromspiegelschaltung vom entgegengesetzten zweiten Leitfähigkeitstyp (npn) sind;

c) daß ein erster (Q1) der beiden Verstärkertransistoren (Q1, Q2) und der als Stromspiegeldiode geschaltete Transistor (Q3) der Verstärkerstromspiegelschaltung (Q3, Q4) in Reihenschaltung miteinander einen ersten Verstärkerschaltungszweig (Q1, Q3) und der zweite Verstärkertransistor (Q2) und der Stromspiegeltransistor (Q4) der Verstärkerstromspiegelschaltung (Q3, Q4) in Reihenschaltung miteinander einen zweiten Verstärkerschaltungszweig (Q2, Q4) bilden;

d) daß beide Reihenschaltungen (Q1, Q3; Q2, Q4) zwischen die beiden Pole (VS, Masse) einer Versorgungsspannungsquelle geschaltet sind; und

e) daß zwischen den ersten Schaltungspunkt (15) und einen ersten (VS) der beiden Pole der Versorgungsspannungsquelle eine Vorspannstromquelle (17) geschaltet ist.

4. Komparator nach Anspruch 3, **dadurch gekennzeichnet, daß** der Verbindungspunkt (21) zwischen dem zweiten Verstärkertransistor (Q2) und dem Stromspiegeltransistor (Q4) den Stromausgang (SA) des Differenzverstärkers (11) bildet.

5. Komparator nach Anspruch 3 oder 4, **dadurch gekennzeichnet, daß** die Emitter der beiden Verstärkertransistoren (Q1, Q2) mit dem ersten Schaltungspunkt (15) und die Emitter der Verstärkerstromspiegeltransistoren (Q3, Q4) mit dem zweiten Pol (Masse) der Versorgungsspannungsquelle verbunden sind.

6. Komparator nach einem der Ansprüche 3 bis 5, **dadurch gekennzeichnet, daß** der als Stromspiegeltransistor wirkende Transistor (Q4) der Verstärkerstromspiegelschaltung (Q3, Q4) eine Emitterfläche aufweist, die n-mal so groß ist wie die Emitterfläche des als Diode geschalteten Transistors (Q3) der Verstärkerstromspiegelschaltung (Q3, Q4).

7. Komparator nach einem der Ansprüche 1 bis 6, **dadurch gekennzeichnet**,

a) daß die bistabile Stromquelle (13) eine erste (Q5, Q6) und eine zweite (Q7 bis Q9) Stromquellen-Stromspiegelschaltung aufweist, die gemeinsam drei Schaltungszweige (Q5, Q7; Q6, Q8; Q9) bilden, von denen ein erster (Q5, Q7) und ein zweiter (Q6, Q8) zwischen die beiden Pole (VS, Masse) der Versorgungsspannungsquelle geschaltet sind;

b) daß ein erster (Q5, Q7) dieser Schaltungszweige eine Reihenschaltung mit einer ersten Stromspiegeldiode (Q5) der ersten Stromquellen-Stromspiegelschaltung (Q5, Q6) und einem ersten Stromspiegeltransistor (Q7) der zweiten Stromquellen-Stromspiegelschaltung (Q7 bis Q9) aufweist;

c) daß ein zweiter (Q6, Q8) dieser Schaltungszweige eine Reihenschaltung mit einem ersten Stromspiegeltransistor (Q6) der ersten Stromquellen-Stromspiegelschaltung (Q5, Q6) und einer Stromspiegeldiode (Q8) der zweiten Stromquellen-Stromspiegelschaltung (Q7 bis Q9) aufweist;

d) daß der dritte Schaltungszweig einen zweiten Stromspiegeltransistor (Q9) der zweiten Stromquellen-Stromspiegelschaltung (Q7 bis Q9) aufweist, dessen Hauptstrecke zwischen einen Pol (VS) der Versorgungsspannungsquelle (VS, Masse) und den Komparatorausgang (A) geschaltet ist;

e) daß zwischen die Hauptstrecke des Stromspiegeltransistors (Q6) der ersten Stromquellen-Stromspiegelschaltung (Q5, Q6) und den auf der Seite dieses Stromspiegeltransistors (Q6) liegenden Pol (Masse) der Versorgungsspannungsquelle (VS, Masse) ein Widerstand (R) geschaltet ist; und

f) daß ein Verbindungspunkt (23) zwischen der Stromspiegeldiode (Q5) der ersten Stromquellen-Stromspiegelschaltung (Q5, Q6) und dem ersten Stromspiegeltransistor (Q7) der zweiten Stromquellen-Stromspiegelschaltung (Q7 bis Q9) den Stromeinspeisungsanschluß (SE) der bistabilen Stromquelle (13) bildet.

8. Komparator nach Anspruch 7, **dadurch gekennzeichnet, daß** die Stromspiegeldiode (Q5) der ersten Stromquellen-Stromspiegelschaltung (Q5, Q6) durch einen diodengeschalteten Transistor gebildet ist

und daß der Stromspiegeltransistor (Q6) der ersten Stromquellen-Stromspiegelschaltung (Q5, Q6) eine Emitterfläche aufweist, die m-mal so groß wie die Emitterfläche des diodengeschalteten Transistors (Q5) der ersten Stromquellen-Stromspiegelschaltung (Q5, Q6) ist.

9. Komparator nach einem der Ansprüche 3 bis 8, **dadurch gekennzeichnet, daß** alle Stromspiegeldioden (Q3, Q5, Q8) durch diodengeschaltete Transistoren gebildet sind.

10. Komparator nach einem der Ansprüche 3 bis 9, **dadurch gekennzeichnet, daß** alle mit dem positiven Pol (VS) der Versorgungsspannungsquelle verbundenen Transistoren (Q1, Q2, Q7 bis Q9) als pnp-Transistoren und alle mit dem negativen Pol (Masse) der Versorgungsspannungsquelle verbundenen Transistoren (Q3 bis Q6) als npn-Transistoren ausgebildet sind.

11. Komparator nach einem der Ansprüche 3 bis 10, **dadurch gekennzeichnet, daß** zur Vergrößerung der Hysterese zwischen den ersten Schaltungspunkt (15) und jeden der beiden damit verbundenen Verstärkertransistoren (Q1, Q2) je eine Impedanz (D1, D2) geschaltet ist.

12. Komparator nach Anspruch 11, **dadurch gekennzeichnet, daß** jede der Impedanzen durch wenigstens eine Diode (D1, D2) gebildet ist.

13. Komparator nach Anspruch 11, **dadurch gekennzeichnet, daß** jede der Impedanzen durch einen Widerstand gebildet ist.

14. Komparator nach einem der Ansprüche 7 bis 13, **dadurch gekennzeichnet, daß** zur Vergrößerung der Hysterese ein Rückkopplungspfad (i10) vorgesehen ist, welcher dem mit dem Referenzpotential (REF) beaufschlagten Eingang des Differenzverstärkers (11) eine dem Ausgangsstrom (i9) der bistabilen Stromquelle (13) proportionale Rückkopplungsspannung zuführt.

**Claims**

1. A comparator with hysteresis in bipolar technology, in which all transistors are formed as bipolar transistors, comprising a voltage/current converter (11) with a voltage input (EIN) forming the comparator input connection, and a current output, **characterized by**

   a) a bistable current source (13) with a current feeding connection (SE) coupled with the current output (SA) of the voltage/current converter (11) and a current output connection forming the comparator output (A); wherein
   b) the bistable current source (13) is currentless in a first stable state and consumes current only in the second stable state; and
   c) the firing current which must be fed to the current feeding connection (SE) to switch the bistable current source (13) from the currentless state to the power-consuming state is different from the quenching current which must be fed to the current feeding connection (SE) to switch the bistable current source from the power-consuming state to the currentless state, to obtain a hysteresis of the comparator.

2. The comparator of claim 1, **characterized in that** the voltage/current converter has a difference amplifier (11) whose first input (+) is fed a voltage signal (VIN) to be monitored, whose second input (-) is subjected to a reference potential (REF), and whose output (SA) is coupled with the current feeding connection (SE) of the bistable current source (13).

3. The comparator of claim 2, **characterized in that**

   a) the difference amplifier (11) has amplifying transistors (Q1, Q2) coupled at a first circuit node (15) and an amplifier current mirror circuit (Q3, Q4) with a current mirror diode (Q3) in the form of a transistor connected as a diode and a current mirror transistor (Q4);
   b) the two amplifying transistors (Q1, Q2) are of a first conductivity type (p-n-p) and the two transistors (Q3, Q4) of the amplifier current mirror circuit are of the opposed second conductivity type (n-p-n);
   c) a first (Q1) of the two amplifying transistors (Q1, Q2) and the transistor (Q3) of the amplifier current mirror circuit (Q3, Q4) connected as a current mirror diode form in series connection with each other a first amplifying circuit branch (Q1, Q3), and the second amplifying transistor (Q2) and the current mirror transistor (Q4) of the amplifier current mirror circuit (Q3, Q4) form in series connection with each other a second amplifying circuit branch (Q2, Q4);
   d) the two series connections (Q1, Q3; Q2, Q4) are connected between the two poles (VS, ground) of a supply voltage source; and
   e) a bias current source (17) is connected between the first circuit node (15) and a first (VS) of the two poles of the supply voltage source.

4. The comparator of claim 3, **characterized in that** the connection point (21) between the second amplifying transistor (Q2) and the current mirror transistor (Q4) forms the current output (SA) of the difference amplifier (11).

5. The comparator of claim 3 or 4, **characterized in that** the emitters of the two amplifying transistors (Q1, Q2) are connected with the first circuit node (15), and the emitters of the amplifier current mirror transistors (Q3, Q4) with the second pole (ground) of the supply voltage source.

6. The comparator of any of claims 3 to 5, **characterized in that** the transistor (Q4) of the amplifier current mirror circuit (Q3, Q4) acting as a current mirror transistor has an emitter area which is n times as great as the emitter area of the diode-connected transistor (Q3) of the amplifier current mirror circuit (Q3, Q4).

7. The comparator of any of claims 1 to 6, **characterized in that**

   a) the bistable current source (13) has first (Q5, Q6) and second (Q7 to Q9) current source current mirror circuits which jointly form three circuit branches (Q5, Q7, Q6, Q8, Q9) of which a first (Q5, Q7) and second (Q6, Q8) are connected between the two poles (VS, ground) of the supply voltage source;
   b) a first (Q5, Q7) of three circuit branches has a series connection with a first current mirror diode (Q5) of the first current source current mirror circuit (Q5, Q6) and a first current mirror transistor (Q7) of the second current source current mirror circuit (Q7 to Q9);
   c) a second (Q6, Q8) of three circuit branches has a series connection with a first current mirror transistor (Q6) of the first current source current mirror circuit (Q5, Q6) and a current mirror diode (Q8) of the second current source current mirror circuit (Q7 to Q9);
   d) the third circuit branch has a second current mirror transistor (Q9) of the second current source current mirror circuit (Q7 to Q9), whose main path is connected between one pole (VS) of the supply voltage source (VS, ground) and the comparator output (A);
   e) a resistor (R) is connected between the main path of the current mirror transistor (Q6) of the first current source current mirror circuit (Q5, Q6) and the pole (ground) of the supply voltage source (VS, ground) located an the side of this current mirror transistor (Q6); and
   f) a connection point (23) between the current mirror diode (Q5) of the first current source current mirror circuit (Q5, Q6) and the first current mirror transistor (Q7) of the second current source current mirror circuit (Q7 to Q9) forms the current feeding connection (SE) of the bistable current source (13).

8. The comparator of claim 7, **characterized in that** the current mirror diode (Q5) of the first current source current mirror circuit (Q5, Q6) is formed by a diode-connected transistor, and the current mirror transistor (Q6) of the first current source current mirror circuit (Q5, Q6) has an emitter area that is m times as great as the emitter area of the diode-connected transistor (Q5) of the first current source current mirror circuit (Q5, Q6).

9. The comparator of any of claims 3 to 8, **characterized in that** all current mirror diodes (Q3, Q5, Q8) are formed by transistors connected as diodes.

10. The comparator of any of claims 3 to 9, **characterized in that** all transistors (Q1, Q2, Q7 to Q9) connected with the positive pole (VS) of the supply voltage source are formed as p-n-p transistors, and all transistors (Q3 to Q6) connected with the negative pole (ground) of the supply voltage source as n-p-n transistors.

11. The comparator of any of claims 3 to 10, **characterized in that** an impedance (D1, D2) is connected between the first circuit node (15) and each of the two amplifying transistors (Q1, Q2) connected therewith for increasing the hysteresis.

12. The comparator of claim 11, **characterized in that** each of the impedances is formed by at least one diode (D1, D2).

13. The comparator of claim 11, **characterized in that** each of the impedances is formed by a resistor.

14. The comparator of any of claims 7 to 13, **characterized in that** a feedback path (i10) is provided for increasing the hysteresis, which feeds a feedback voltage proportional to the output current (i9) of the bistable current source (13) to the input of the difference amplifier (11) subjected to the reference potential (REF).

## Revendications

1. Comparateur à hystérésis en technologie bipolaire, dans lequel tous les transistors sont des transistors bipolaires, comprenant un convertisseur tension/courant (11) avec une entrée en tension (EIN) constituant l'entrée du comparateur et une sortie en courant ; **caractérisé par**

   a) une source de courant bistable (13) dont l'alimentation en courant (SE) est couplée au courant de sortie (SA) du convertisseur tension/courant (11) et dont le courant de sortie constitue la sortie du comparateur (A) ; où
   b) la source de courant bistable (13) est à courant nul dans un premier état stable et consomme du courant seulement dans le second état stable ; et
   c) le courant d'amorçage, qui doit être amené à la borne d'alimentation en courant (SE) pour faire commuter la source de courant bistable (13) de l'état à courant nul à l'état consommant du courant, et le courant d'extinction, qui doit être injecté à la borne d'alimentation en courant (SE) pour faire commuter la source de courant bistable de l'état consommant du courant à l'état à courant nul, sont différents l'un de l'autre afin d'obtenir une hystérésis du comparateur.

**2.** Comparateur selon la revendication 1, **caractérisé en ce que** le convertisseur tension/courant comporte un amplificateur différentiel (11), à une entrée (+) duquel est injecté un signal de tension de surveillance (VIN), dont la seconde entrée (-) est alimentée par un potentiel de référence (REF) et dont la sortie (SA) est couplée à la borne d'alimentation en courant (SE) de la source de courant bistable (13).

**3.** Comparateur selon la revendication 2, **caractérisé en ce que** :

a) l'amplificateur différentiel (11) comprend, à un premier noeud de connexion (15), des transistors amplificateurs couplés (Q1, Q2) et un montage de miroir de courant amplificateur (Q3, Q4) comportant une diode du miroir de courant (Q3) sous forme d'un transistor monté en diode et un transistor de miroir de courant (Q4) ;
b) les deux transistors amplificateurs (Q1, Q2) sont d'un premier type de conductivité (PNP) et les deux transistors (Q3, Q4) du montage de miroir de courant amplificateur, d'un second type, inverse, de conductivité (NPN) ;
c) un premier (Q1) des deux transistors amplificateurs (Q1, Q2) et le transistor monté en diode du miroir de courant (Q3) du montage de miroir de courant amplificateur (Q3, Q4) en montage série l'un avec l'autre forment une première branche du montage amplificateur (Q1, Q3) et le second transistor amplificateur (Q2) et le transistor (Q4) du miroir de courant du montage de miroir de courant amplificateur (Q3, Q4) connectés en série forment une deuxième branche du montage amplificateur (Q2, Q4) ;
d) les deux montages série (Q1, Q3 ; Q2, Q4) sont connectés entre les deux bornes (VS, masse) d'une source de tension d'alimentation ; et
e) entre le premier noeud de connexion (15) et la première (VS) des deux bornes de la source de tension d'alimentation, est connectée une source de courant de polarisation (17).

**4.** Comparateur selon la revendication 3, **caractérisé en ce que** le noeud de connexion (21), entre le deuxième transistor amplificateur (Q2) et le transistor (Q4) du miroir de courant, constitue la borne de sortie en courant (SA) de l'amplificateur différentiel (11).

**5.** Comparateur selon la revendication 3 ou 4, **caractérisé en ce que** les émetteurs des deux transistors amplificateurs (Q1, Q2) sont connectés au premier noeud de connexion (15) et les émetteurs des transistors (Q3, Q4) du miroir de courant amplificateur sont connectés à la deuxième borne (masse) de la source de tension d'alimentation.

**6.** Comparateur selon l'une quelconque des revendications 3 à 5, **caractérisé en ce que** le transistor (Q4) agissant comme transistor du miroir de courant du montage de miroir de courant amplificateur (Q3, Q4) a une surface d'émetteur qui est n fois plus grande que la surface d'émetteur du transistor monté en diode (Q3) du montage de miroir de courant amplificateur (Q3, Q4) .

**7.** Comparateur selon l'une quelconque des revendications 1 à 6, **caractérisé en ce que** :

a) la source de courant bistable (13) comprend une première (Q5, Q6) et une seconde (Q7 à Q9) source de courant-montage de miroir de courant, qui, ensemble, forment trois branches du montage (Q5, Q7 ; Q6, Q8 ; Q9) dont une première (Q5, Q7) et une deuxième branche (Q6, Q8) sont connectées entre les deux bornes (VS, masse) de la source de tension d'alimentation ;
b) une première (Q5, Q7) des branches du montage comprend un montage série d'une première diode du miroir de courant (Q5) de la première source de courant-montage de miroir de courant (Q5, Q6) avec un premier transistor du miroir de courant (Q7) de la seconde source de courant-montage de miroir de courant (Q7 à Q9) ;
c) une deuxième (Q6, Q8) des branches du montage comprend un montage série d'un premier transistor du miroir de courant (Q6) de la première source de courant-montage en miroir de courant (Q5, Q6) avec une diode du miroir de courant (Q8) de la seconde source de courant-montage en miroir de courant (Q7 à Q9) ;
d) la troisième branche du montage comprend un deuxième transistor du miroir de courant (Q9) de la seconde source de courant-montage en miroir de courant (Q7 à Q9), dont les bornes principales sont connectées entre une borne (VS) de la source de tension d'alimentation (VS, masse) et la sortie (A) du comparateur ;
e) une résistance (R) est connectée entre une borne principale du transistor du miroir de courant (Q6) de la première source de courant-montage de miroir de courant (Q5, Q6) et la borne (masse) de la source de tension d'alimentation (VS, masse) du côté de ce transistor du miroir de courant (Q6) ; et
f) un noeud de connexion (23) entre la diode du miroir de courant (Q5) de la première source de courant-montage de miroir de courant (Q5, Q6) et le premier transistor du miroir de courant (Q7) de la seconde source de courant-montage de miroir de courant (Q7 à Q9) constitue la borne d'alimentation en courant (SE) de la source de courant bistable (13).

8. Comparateur selon la revendication 7, **caractérisé en ce que** la diode du miroir de courant (Q5) de la première source de courant-montage de miroir de courant (Q5, Q6) est constituée d'un transistor monté en diode et **en ce que** le transistor du miroir de courant (Q6) de la première source de courant-montage de miroir de courant (Q5, Q6) a une surface d'émetteur qui est m fois plus grande que la surface d'émetteur du transistor monté en diode (Q5) de la première source de courant-montage de miroir de courant (Q5, Q6).

9. Comparateur selon l'une quelconque des revendications 3 à 8, **caractérisé en ce que** toutes les diodes des miroirs de courant (Q3, Q5, Q8) sont constituées de transistors montés en diode.

10. Comparateur selon l'une quelconque des revendications 3 à 9, **caractérisé en ce que** tous les transistors (Q1, Q2, Q7 à Q9) connectés au pôle positif (VS) de la source d'alimentation en tension sont des transistors PNP et tous les transistors (Q3 à Q6) connectés au pôle négatif (masse) de la source d'alimentation en tension sont des transistors NPN.

11. Comparateur selon l'une quelconque des revendications 3 à 10, **caractérisé en ce que**, afin d'augmenter l'hystérésis, une impédance (D1, respectivement, D2) est connectée entre le premier noeud de connexion (15) et chacun des deux transistors amplificateurs (Q1, Q2) qui sont connectés à ce noeud.

12. Comparateur selon la revendication 11, **caractérisé en ce que** chacune des impédances est réalisée au moyen d'au moins une diode (D1, D2).

13. Comparateur selon la revendication 11, **caractérisé en ce que** chacune des impédances est réalisée au moyen d'une résistance.

14. Comparateur selon l'une quelconque des revendications 7 à 13, **caractérisé en ce que**, afin d'augmenter l'hystérésis, il est prévu une boucle de rétroaction (i10) qui amène, à l'entrée de l'amplificateur différentiel (11) dans laquelle est injecté le potentiel de référence (REF), une tension de rétroaction proportionnelle au courant de sortie (i9) de la source de courant bistable (13).

FIG.1

FIG.5

FIG.6

# FIG. 2

EP 0 700 157 B1

FIG. 3

i6 [μA]

3

2

1

LÖSCHUNG DER
STROMQUELLE

H = HYSTERESE

H

ZÜNDUNG DER STROMQUELLE

RÜCKKEHR ZU iOUT=0 BEI SÄTTIGUNG VON Q4

−2        −1        −0,5    0        1        2        3        4        iout [μA]

EP 0 700 157 B1

FIG. 4

EP 0 700 157 B1